# EUROPEAN PATENT APPLICATION

(11) **EP 4 418 831 A1**
(43) Date of publication of application: **21.08.2024**
(21) Application number: 22880618.8
(22) Date of filing: 04.08.2022
(51) Int. Cl.: H10B 99/00, H01L 27/105, H01L 21/363, H01L 21/365, H01L 29/06, H01L 29/15, H10N 70/00

(54) **METHOD FOR MANUFACTURING CRYSTALLIZED LAMINATED STRUCTURE**

(30) Priority: 15.10.2021 JP 2021169702
(71) Applicant: National Institute of Advanced Industrial Science and Technology, Tokyo 100-8921 (JP); ULVAC, Inc., Chigasaki-shi, Kanagawa 253-8543 (JP)
(72) Inventor: TOMINAGA, Junji, Tsukuba-shi, Ibaraki 305-8560 (JP); MIYATA, Noriyuki, Tsukuba-shi, Ibaraki 305-8560 (JP); ASANUMA, Shutaro, Tsukuba-shi, Ibaraki 305-8560 (JP); MIYAGUCHI, Yuusuke, Chigasaki-shi, Kanagawa 253-8543 (JP); SAITO, Kazuya, Chigasaki-shi, Kanagawa 253-8543 (JP); JINBO, Takehito, Chigasaki-shi, Kanagawa 253-8543 (JP); HORITA, Kazumasa, Chigasaki-shi, Kanagawa 253-8543 (JP); MASUDA, Takeshi, Chigasaki-shi, Kanagawa 253-8543 (JP)
(74) Representative: Gille Hrabal Partnerschaftsgesellschaft mbB Patentanwälte
(86) International application number: PCT/JP2022/029978
(87) International publication number: WO 2023/062918

(57) **Abstract**

Provided is a method of manufacturing a crystallized stacked structural body excellent in manufacturing efficiency. The present invention is characterized by including: a stacked structural body-forming step of forming a stacked structural body (7) in which an Sb₂Te₃ layer (5) having a thickness of from 2 nm to 10 nm and a GeTe layer (6) having a thickness of more than 0 nm and 4 nm or less are stacked, and a trace addition element (S or Se) is incorporated at a content of from 0.05 at% to 10.0 at% into the GeTe layer (6) on an orientation control layer (4) configured to give, to the Sb₂Te₃ layer (5) and the GeTe layer (6) at the time of their crystallization, a common crystal axis, the step being performed under a temperature of less than 100°C including room temperature; an Sb₂Te₃ layer-crystallizing step of crystallizing the Sb₂Te₃ layer (5) by heating and holding the stacked structural body (7) at a first crystallization temperature of 100°C or more and less than 170°C; and a GeTe layer-crystallizing step of crystallizing the GeTe layer (6) by heating and holding the stacked structural body (7) in which the Sb₂Te₃ layer (5) is crystallized at a second crystallization temperature of 170°C or more and 400°C or less.

## Description

### Technical Field

The present invention relates to a method of manufacturing a crystallized stacked structural body by which a crystallized stacked structural body in which an Sb₂Te₃ compound layer and a GeTe compound layer are stacked and crystallized is efficiently manufactured.

### Background Art

There has been known a superlattice-type phase-change memory capable of a memory operation with a superlattice obtained by crystallizing the stacked structural body of an Sb₂Te₃ compound layer and a GeTe compound layer (see Patent Documents 1 and 2).

The stacked structural body is generally formed by using a vacuum film-forming apparatus. The structural body is typically formed by using a sputtering apparatus. For example, a compound plate whose composition is Sb₂Te₃ and a compound plate whose composition is Ge₁Te₁ are used as targets. An argon gas is used for each of the targets to generate plasma, and argon ions are caused to collide with the surface of the target to eject target atoms, followed by the formation of the deposition layer of the target atoms, which have been scattered, on a substrate placed on a counter electrode arranged to face the target.

At this time, when the temperature of the substrate is low, the deposition layer is brought into an amorphous state. Accordingly, to crystallize the stacked structural body, the substrate is heated in advance to the higher one of crystallization temperatures intrinsic to a Ge₁Te₁ compound and an Sb₂Te₃ compound, and sputtering is performed while the temperature is held. Typically, the crystallization temperature of the Ge₁Te₁ compound is 230°C and the crystallization temperature of the Sb₂Te₃ compound is around 70°C. Accordingly, an Sb₂Te₃ compound layer and a GeTe compound layer are stacked on the substrate in the state of being heated to 230°C, which is the higher temperature, to provide a superlattice structure in which these compound layers are crystallized.

Accordingly, a heating condition for the substrate is set between 200°C and 250°C in most cases. The superlattice structure having high quality is hardly obtained at any temperature except the foregoing.

In addition, it has been reported for the stacked structural body that interface diffusion (interface mixing) is liable to occur at an interface between the Sb₂Te₃ compound layer and the GeTe compound layer, and hence a satisfactory interface is hardly obtained (see Non-Patent Documents 1 and 2).

A GeSbTe compound layer different in kind from the Sb₂Te₃ compound layer and the GeTe compound layer is formed at the interface, and crystallizes at its intrinsic crystallization temperature. As expected, the crystallization temperature is present between the crystallization temperature of the Ge₁Te₁ compound and the crystallization temperature of the Sb₂Te₃ compound. Accordingly, when the GeSbTe compound layer is formed so as to have the composition of Ge₂Sb₂Te₅, the crystallization temperature appears at around 160°C. In addition, when a GeSbTe crystal layer is formed, there are observed X-ray diffraction peaks of such as [200] and [220] peaks that are not observed in the superlattice structure formed of the Sb₂Te₃ compound layer and the GeTe compound layer.

The GeSbTe crystal layer is responsible for the function loss of the superlattice-type phase-change memory because the layer is not involved in its memory operation.

To solve such problems, the inventors of the present invention have discovered that the superlattice structure having high quality in which the interface diffusion (interface mixing) is suppressed can be produced through the formation of the stacked structural body by the addition of a slight amount of a second chalcogen element (sulfur or selenium) to each of the targets in addition to Te, which is a first chalcogen element serving as the main component of the GeTe compound layer. Thus, the inventors have obtained a solution to the superlattice-type phase-change memory in terms of function (see Patent Document 3 and Non-Patent Document 3). The addition of the chalcogen atom to the GeTe compound layer suppresses the formation of the GeSbTe crystal layer.

However, in a real manufacturing scene, the above-mentioned manufacturing condition, that is, the formation of the stacked structural body after the heating of the substrate to from 200°C to 250°C serves as a large burden, and hence the situation is that a further improvement of the condition has been expected.

That is, under the manufacturing condition, the following steps are required for each manufacture of the individual superlattice-type phase-change memory. First, the following needs to be performed: the substrate is loaded into a sputtering apparatus, and the substrate is heated to from 200°C to 250°C, followed by the formation of a structural layer for forming the stacked structural body as a crystal state by sputtering while the temperature is maintained. Next, the following needs to be performed: the heating of the substrate is stopped, and the cooling of the substrate to the temperature at which the substrate can be safely removed is waited for, followed by the removal of the substrate on which the stacked structural body has been formed from the sputtering apparatus.

Accordingly, a temperature increase time for increasing the temperature of the substrate at low temperature to a temperature as high as from 200°C to 250°C, a waiting time required for the temperature to become stable at the target temperature to which the temperature of the substrate is increased and a cooling time for safely removing the substrate, the times occurring for each such manufacture of the individual superlattice-type phase-change memory, become longer than a formation time for the stacked structural body, and hence limit the manufacturing speed of the memory. Thus, when the superlattice-type phase-change memory is continuously manufactured in a large amount, its manufacturing time lengthens to inhibit efficient manufacture of the superlattice-type phase-change memory.

### Prior Art Documents

### Patent Documents

Patent Document 1: JP 4635236 B2
Patent Document 2: JP 6238495 B2
Patent Document 3: WO 2020/012916 A1

### Non-Patent Documents

Non-Patent Document 1: R. Wang, V. Bragaglia, J. E. Boschker and R. Calarco, "Intermixing during Epitaxial Growth of van der Waals bonded Normal GeTe/Sb2Te3 Superlattices", Cryst. Growth Des. 16, 3596-3601 (2016)

Non-Patent Document 2: A. Lotnyk, I. Hilmi, U. Ross and B. Rauschenbach, "Van Der Waals interfacial bonding and intermixing in GeTe-Sb2Te3-based superlattices", Nano Res. 11, 1676-1686 (2018).

Non-Patent Document 3: J. Tominaga and H. Awano, "Intermixing suppression through the interface in GeTe/Sb2Te3 superlattice", Appl. Phys. Express 13, 075503 (2020).

### Disclosure of the Invention

### Problems to be solved by the Invention

A problem to be solved by the present invention is to solve the various problems in the related art to achieve the following object. That is, the problem to be solved by the present invention is to provide a method of manufacturing a crystallized stacked structural body excellent in manufacturing efficiency.

The inventors of the present invention have made extensive investigations with a view to solving the problem and have obtained the following finding.

The reason why the manufacturing time lengthens in the related-art method lies in the following manufacturing sequence: a stacked structural body film-forming step which is performed by heating the respective compound layers of the Sb₂Te₃ compound layer and the GeTe compound layer to the temperature range and forming a film of each of the compounds as a crystal state under a state in which its temperature is stably held, and a cooling step of cooling the temperature to room temperature to remove the stacked structural body are continuous steps to be performed in the one vacuum film-forming apparatus, and the sequence does not proceed to the formation of the next crystallized stacked structural body until the formation of the one crystallized stacked structural body is performed.

Herein, a manufacturing process for the crystallized stacked structural body is performed while being separated into the following two processes: a film formation process in which only film formation is performed under low temperature less than the crystallization temperature of one of the compounds; and a crystallization process in which only crystallization is performed under high temperature equal to or more than the crystallization temperature. When those processes are performed in parallel with different apparatus, a manufacturing time for the structural body is shortened all at once.

That is, after the film formation process of the first time, the crystallization process of the first time is performed. However, during the performance of the crystallization process of the first time, the film formation process of the second time is advanced with another apparatus. Accordingly, the manufacturing time can be simply shortened by a time period to wait for the completion of the crystallization process of the first time.

In addition, when the film formation process and the crystallization process are separate processes, the crystallization process can be a process to be performed for the plurality of stacked structural bodies at a time. In other words, the crystallization process becomes batch processing for the plurality of stacked structural bodies. Accordingly, a manufacturing time per stacked structural body obtained by dividing the total manufacturing time by the number of the stacked structural bodies of interest is significantly shortened as compared to a manufacturing time for one stacked structural body when the stacked structural body is manufactured by a process in which the film formation process and the crystallization process are continuous with each other.

However, when such separate processes are adopted, whether or not a structure equivalent to the crystallized stacked structural body manufactured by the related-art method is really obtained becomes a problem. This is because when the structure is not obtained, the superlattice-type phase-change memory to be finally manufactured does not have any required function, and hence the meaning of the manufacture itself is lost.

In this regard, the inventors of the present invention have obtained the demonstration result that even when the separate processes are adopted, the structure equivalent to the crystallized stacked structural body manufactured by the related-art method is obtained. In addition, the inventors have succeeded in elucidating a condition for obtaining such structure.

Specifically, the inventors have obtained the following findings: (1) when the film formation process is performed under a room-temperature environment in an unheated state, even in the case where in the crystallization process, the stacked structural body is heated and held only at the higher crystallization temperature of the crystallization temperature intrinsic to the GeTe compound layer and the crystallization temperature intrinsic to the Sb₂Te₃ compound layer in conformity with the related-art method, the structure equivalent to the crystallized stacked structural body manufactured by the related-art method is not obtained, but in the case where the heating and the holding are performed in two stages at the respective crystallization temperatures of the GeTe compound layer and the Sb₂Te₃ compound layer, the structure equivalent to the crystallized stacked structural body manufactured by the related-art method is obtained; (2) the second chalcogen element to be added to the GeTe compound layer for suppressing interface diffusion affects the crystallization temperature intrinsic to the GeTe compound layer, and hence a temperature range required to obtain the structure equivalent to the crystallized stacked structural body manufactured by the related-art method is present in a temperature range different from the intrinsic crystallization temperature; and (3) the crystallization temperature of the GeTe compound layer in a single-layer state and that in a stacked state differ from each other, and hence a temperature range required to obtain the structure equivalent to the crystallized stacked structural body manufactured by the related-art method is present in a temperature range different from the crystallization temperature intrinsic to the GeTe compound layer.

### Means for solving the Problems

The present invention is based on the above-mentioned findings, and a solution to the above-mentioned problem is specifically as described below.
<1> A method of manufacturing a crystallized stacked structural body, including: a stacked structural body-forming step of forming a stacked structural body in which an Sb₂Te₃ layer, which contains Sb₂Te₃ as a main component thereof and has a thickness of from 2 nm to 10 nm, and a GeTe layer, which contains GeTe as a main component thereof and has a thickness of more than 0 nm and 4 nm or less, are stacked, and at least one trace addition element selected from the group consisting of S and Se is incorporated at a content of from 0.05 at% to 10.0 at% into the GeTe layer on an orientation control layer configured to give, to the Sb₂Te₃ layer and the GeTe layer at a time of crystallization thereof, a common crystal axis, the step being performed under a temperature of less than 100°C including room temperature; an Sb₂Te₃ layer-crystallizing step of crystallizing the Sb₂Te₃ layer by heating and holding the stacked structural body at a first crystallization temperature of 100°C or more and less than 170°C; and a GeTe layer-crystallizing step of crystallizing the GeTe layer by heating and holding the stacked structural body in which the Sb₂Te₅ layer is crystallized at a second crystallization temperature of 170°C or more and 400°C or less.
<2> The method of manufacturing a crystallized stacked structural body according to the above-mentioned item <1>, wherein the trace addition element is S.
<3> The method of manufacturing a crystallized stacked structural body according to the above-mentioned item <1> or <2>, wherein the stacked structural body-forming step is a step of forming the stacked structural body by using, as the orientation control layer, at least one underlayer selected from the group consisting of a GeTe underlayer, which contains GeTe as a main component thereof and has a thickness of from 3 nm to 10 nm, and an Sb₂Te₃ underlayer, which contains Sb₂Te₃ as a main component thereof and has a thickness of from 3 nm to 10 nm, and stacking the Sb₂Te₃ layer and the GeTe layer in the stated order on the underlayer when the underlayer is the GeTe underlayer or stacking the GeTe layer and the Sb₂Te₃ layer in the stated order on the underlayer when the underlayer is the Sb₂Te₃ underlayer.
<4> The method of manufacturing a crystallized stacked structural body according to any one of the above-mentioned items <1> to <3>, wherein the stacked structural body-forming step is a step of forming the stacked structural body on the orientation control layer in an unheated state under room temperature.
<5> The method of manufacturing a crystallized stacked structural body according to any one of the above-mentioned items <1> to <4>, wherein the Sb₂Te₃ layer-crystallizing step and the GeTe layer-crystallizing step are performed for the plurality of stacked structural bodies.
<6> The method of manufacturing a crystallized stacked structural body according to any one of the above-mentioned items <1> to <5>, wherein at least one step selected from the group consisting of the Sb₂Te₃ layer-crystallizing step and the GeTe layer-crystallizing step is performed under an air atmosphere.
<7> The method of manufacturing a crystallized stacked structural body according to any one of the above-mentioned items <1> to <6>, wherein the Sb₂Te₃ layer-crystallizing step is performed as at least one step selected from the group consisting of a step of heating part of the stacked structural body and a step of heating an entirety of the stacked structural body, and the GeTe layer-crystallizing step is a step of heating the stacked structural body including part or an entirety of a region of the stacked structural body heated in the Sb₂Te₃ layer-crystallizing step.
<8> The method of manufacturing a crystallized stacked structural body according to any one of the above-mentioned items <1> to <7>, further including an epitaxial growth layer-forming step of forming an epitaxial growth layer on the stacked structural body after the GeTe layer-crystallizing step.

### Advantageous Effects of the Invention

According to the present invention, the various problems in the related art can be solved. Specifically, the method of manufacturing a crystallized stacked structural body excellent in manufacturing efficiency can be provided.

### Brief Description of the Drawings

FIG. 1 is an explanatory view of a crystallized stacked structural body manufactured by a method of manufacturing a crystallized stacked structural body of the present invention.
FIG. 2 is an explanatory view for illustrating a modification of the crystallized stacked structural body.
FIG. 3 is a graph for showing a relationship between the substitution concentration at which a Te atom in a GeTe layer (Ge₍₄₅₎Te₍₅₅₋ₓ₎S₍ₓ₎) is substituted with a S atom and the crystallization temperature of the layer.
FIG. 4 is a graph for showing the measurement results of X-ray diffractometry for a crystallized stacked structural body according to Reference Example 1.
FIG. 5 is a graph for showing the measurement results of X-ray diffractometry at the stage of the crystallization of an Sb₂Te₃ layer in Example 1.
FIG. 6 is a graph for showing the measurement results of X-ray diffractometry for a crystallized stacked structural body according to Example 1.
FIG. 7 is a photograph for showing an image obtained by observing a section of the crystallized stacked structural body according to Example 1 with a high-resolution transmission electron microscope.
FIG. 8 is a photograph for showing an image obtained by observing a section of a crystallized stacked structural body according to Example 2 with a high-resolution transmission electron microscope.

### Mode for carrying out the Invention

### (Method of manufacturing Crystallized Stacked Structural Body)

A method of manufacturing a crystallized stacked structural body of the present invention includes a stacked structural body-forming step, an Sb₂Te₃ layer-crystallizing step and a GeTe layer-crystallizing step, and may include any other step as required.

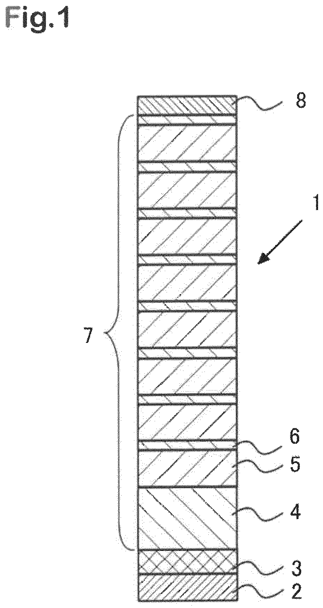

An example of the method of manufacturing a crystallized stacked structural body is described below with reference to the drawings. FIG. 1 is an explanatory view of the crystallized stacked structural body manufactured by the manufacturing method.

### <Stacked Structural Body-forming Step>

The stacked structural body-forming step is a step of forming a stacked structural body 7 in which an Sb₂Te₃ layer 5 and a GeTe layer 6 are stacked, and a trace addition element is incorporated into the GeTe layer 6 on an orientation control layer 4 configured to give, to the Sb₂Te₃ layer 5 and the GeTe layer 6 at the time of their crystallization, a common crystal axis, the step being performed under a temperature of less than 100°C including room temperature.

The Sb₂Tea layer 5 is formed as a layer containing Sb₂Te₃ as its main component and having a thickness of from 2 nm to 10 nm. When the thickness is from 2 nm to 10 nm, a c-axis-oriented crystal structure is easily obtained at the time of the crystallization, and hence a crystal structure sharing a crystal axis with the GeTe layer 6 is easily obtained.

A method of forming the Sb₂Te₃ layer 5 is not particularly limited, and examples thereof may include known vacuum film-forming methods, such as a sputtering method, a molecular beam epitaxy method, an ALD method and a CVD method.

In addition, a material for forming the Sb₂Te₃ layer 5 is not particularly limited, and an SbTe compound material (e.g., an Sb₃₀Te₇₀ compound material) adjusted so that the composition of Sb₂Te₃ may be obtained at the time of its stacking may be used. A commercial material (manufactured by Mitsubishi Materials Corporation) or a material produced by a known method may be used as the SbTe compound material.

The GeTe layer 6 is formed as a layer containing GeTe as its main component and having a thickness of more than 0 nm and 4 nm or less. When the thickness is more than 4 nm, the layer may show an independent and intrinsic characteristic, and in the case where a superlattice-type phase-change memory is formed, its characteristic may be affected.

The term "main component" as used herein means that the component is a compound of atoms for forming the basic unit cell of a layer, and when the layer contains the trace addition element (S or Se), the term means that the component is a compound of an atom of the trace addition element and the atoms for forming the basic unit cell.

The GeTe layer 6 contains the trace addition element that is at least one of sulfur (S) and selenium (Se). As with an element Te in the GeTe layer 6, those elements are each an element having such a property as to be classified into a chalcogen element. Those atoms form the basic unit cell while substituting for Te atoms in the GeTe layer 6.

The trace addition element is added for the purpose of suppressing the formation of a GeSbTe crystal layer at an interface between the Sb₂Te₃ layer 5 and the GeTe layer 6 by substitution between an Sb atom and a Ge atom due to interface diffusion (interface mixing) at the interface.

Of those described above, sulfur (S) is preferred as the trace addition element from the viewpoint of effectively suppressing the formation of the GeSbTe crystal layer.

The content of the trace addition element in each of the Sb₂Te₃ layer 5 and the GeTe layer 6 is from 0.05 at% to 10.0 at%, suitably from 1.0 at% to 5.0 at% from the viewpoint of obtaining a superlattice structure in which the formation of the GeSbTe crystal layer is suppressed. When the content of the trace addition element is excessively large, the phase-change characteristic of the superlattice-type phase-change memory is impaired, and when the content is excessively small, the formation of the GeSbTe crystal layer is hardly suppressed.

A method of forming the GeTe layer 6 is not particularly limited, and examples thereof may include known vacuum film-forming methods, such as a sputtering method, a molecular beam epitaxy method, an ALD method and a CVD method.

The method of forming the GeTe layer 6 is not particularly limited, and a compound material obtained by adding the trace addition element to a GeTe compound material (Ge₄₅Te₅₅) adjusted so that the composition of Ge₁Te₁ may be obtained at the time of its stacking, for example, a compound material in which Te(55-x) of the GeTe compound material is substituted with the composition of S(x) may be used. A commercial material (manufactured by Mitsubishi Materials Corporation) or a material produced by a known method may be used as such compound material.

In the stacked structural body-forming step, one of each of the Sb₂Te₃ layer 5 and the GeTe layer 6 may be stacked, or the step may be a step of forming the stacked structural body 7 by alternately and repeatedly stacking the Sb₂Te₃ layer 5 and the GeTe layer 6 as illustrated in FIG. 1.

When the Sb₂Te₃ layer 5 and the GeTe layer 6 are alternately and repeatedly stacked, the number of the stacked layers is not limited to the illustrated example (a total of 16 layers formed of 8 of each of the layers).

When each of the Sb₂Te₃ layer 5 and the GeTe layer 6 is counted as one layer, the number of the stacked layers is preferably set to from about 10 to about 50 from the viewpoint of achieving a satisfactory memory operation in the superlattice-type phase-change memory.

The stacked structural body 7 is formed on the orientation control layer 4 configured to give, to the Sb₂Te₅ layer 5 and the GeTe layer 6 at the time of the crystallization, the common crystal axis.

When the stacked structural body 7 is formed on the orientation control layer 4, the following crystal orientation property is imparted to the Sb₂Te₅ layer 5 and the GeTe layer 6 at the time of the crystallization, and hence the stacked structural body 7 is given a superlattice structure formed of the crystal layers of the Sb₂Te₃ layer 5 and the GeTe layer 6: the layers undergo oriented growth while sharing the (111) plane direction axis of a GeTe crystal having a cubic crystal structure and the (0001) plane direction axis of an Sb₂Te₃ crystal having a hexagonal crystal structure.

In the example of FIG. 1, the orientation control layer 4 includes a GeTe underlayer, which contains GeTe as its main component and has a thickness of from 3 nm to 10 nm.

When the orientation control layer 4 includes the GeTe underlayer, the stacked structural body 7 is formed by stacking the Sb₂Te₃ layer 5 and the GeTe layer 6 in the stated order on the GeTe underlayer.

The GeTe underlayer may be formed by the same formation method as that for the GeTe layer 6, and the trace addition element may be added thereto as with the GeTe layer 6 from the viewpoint of suppressing the occurrence of interface diffusion (interface mixing) between the GeTe underlayer and the Sb₂Te₃ layer 5 thereon. The GeTe underlayer is crystallized together with the GeTe layer 6 at the time of heating in the GeTe layer-crystallizing step to be described in detail later.

In addition, the GeTe underlayer may be formed on an arbitrary basic underlayer. When the GeTe underlayer is formed as a layer free of the trace addition element, the GeTe compound material (Ge₄₅Te₅₅) only needs to be used as a formation material therefor.

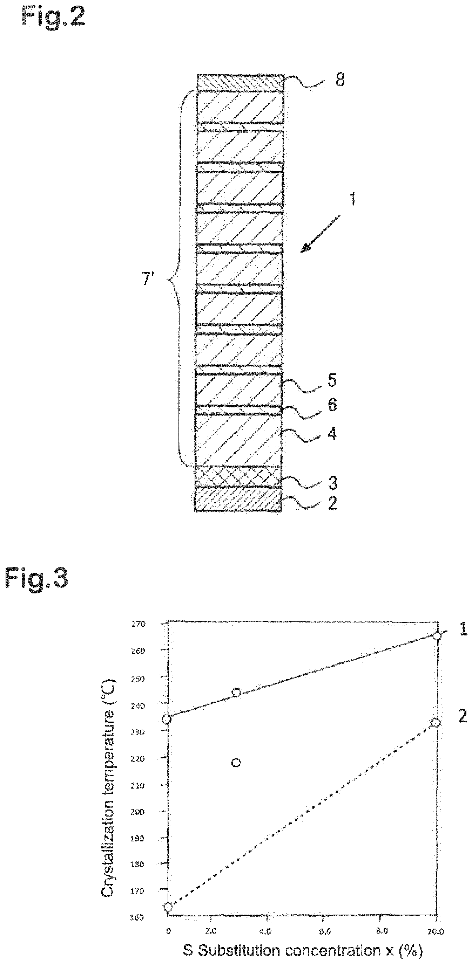

In addition, the orientation control layer 4 may be formed of an Sb₂Te₃ underlayer, which contains Sb₂Te₃ as its main component and has a thickness of from 3 nm to 10 nm. In this case, as illustrated in FIG. 2, a stacked structural body 7' is formed by stacking the GeTe layer 6 and the Sb₂Te₃ layer 5 in the stated order on the orientation control layer 4 serving as the Sb₂Te₃ underlayer. The stacked structural body is identical to the stacked structural body 7 except the foregoing. FIG. 2 is an explanatory view for illustrating a modification of the crystallized stacked structural body.

The Sb₂Te₃ underlayer may be formed by the same formation method as that for the Sb₂Te₃ layer 5 except its thickness. The Sb₂Te₃ underlayer is crystallized together with the Sb₂Te₃ layer 5 at the time of heating in the Sb₂Te₃ underlayer-crystallizing step to be described in detail later.

In addition, when a silicon (Si) layer formed of, for example, a known Si substrate or Si film, or an electrode layer formed of tungsten (W) or TiN is used as a basic underlayer, and the Sb₂Te₃ underlayer is formed on the basic underlayer, the common crystal axis is easily given to the Sb₂Te₃ layer 5 and the GeTe layer 6 at the time of the crystallization.

In each of FIG. 1 and FIG. 2, a substrate is represented by reference numeral 2 and the basic underlayer is represented by reference numeral 3.

When the orientation control layer 4 is formed of the GeTe underlayer or the Sb₂Te₃ underlayer, a manufacturing process for the crystallized stacked structural body is simplified because these underlayers may be formed in the same manner as with the Sb₂Te₃ layer 5 and the GeTe layer 6 as described above.

In addition, it has been known that in the related-art method of manufacturing the stacked structural body based on film formation by heating, the Sb₂Te₃ underlayer is used as the orientation control layer. However, in the present invention in which heating is performed in two stages at two crystallization temperatures, as described in the section "Examples" to be described later, the oriented growth of the respective crystal layers of the Sb₂Te₃ layer 5 and the GeTe layer 6 through use of the GeTe underlayer as well as the Sb₂Te₃ underlayer as a template is possible, and hence the degree of freedom in material selection is increased.

In addition, when the orientation control layer 4 includes the GeTe underlayer, in addition to a silicon (Si) layer formed of, for example, a known Si substrate or Si film, or an electrode layer formed of tungsten (W) or TiN, the basic underlayer 3 formed of an arbitrary material may be applied. This is because each Sb₂Te₃ layer 5 formed on the GeTe underlayer and crystallized through the Sb₂Te₃ layer-crystallizing step (first-stage crystallizing step) acts as an orientation film not only on the GeTe layer 6 adjacent to the upper portion of each Sb₂Te₃ layer 5 but also on the GeTe layer 6 adjacent to the lower portion thereof at the time of the GeTe layer-crystallizing step (second-stage crystallizing step). Accordingly, the basic underlayer 3 when the orientation control layer 4 includes the GeTe underlayer is not particularly limited, and hence may be selected in accordance with purposes. For example, a heat-resistant plastic film formed of a polyimide or the like is permitted. In addition, the GeTe underlayer may be directly formed on the substrate 2 (known heat-resistant substrate) while the formation of the basic underlayer 3 is omitted.

The orientation control layer 4 may be formed as a layer except the GeTe underlayer and the Sb₂Te₃ underlayer, and may be appropriately selected from known configurations.

Such configuration is, for example, the configuration of an orientation control layer formed of at least one of germanium, silicon, tungsten, germanium-silicon, germanium-tungsten and silicon-tungsten as disclosed in WO 2015/174240 A1.

The stacked structural body-forming step is performed under a temperature of less than 100°C including room temperature. Specifically, with reference to FIG. 1 again, the stacked structural body 7 is formed under such a condition that a temperature condition for the orientation control layer 4 (the temperature of the stacked structural body 7 is set by the temperature of the substrate 2 through the basic underlayer 3 and the orientation control layer 4) is set to less than 100°C.

The temperature condition of less than 100°C is a temperature condition distinguished from a first crystallization temperature in the Sb₂Te₃ layer-crystallizing step to be described in detail later, and in actuality, the condition is preferably 50°C or less for reducing a temperature increase time and a cooling time when after a first film formation process, the next film formation process is performed with the same vacuum film-forming apparatus. In particular, when the stacked structural body 7 is formed on the orientation control layer 4 in an unheated state under room temperature, there are no time periods required to increase the temperature of, and cool, the orientation control layer 4, and hence a manufacturing time for the crystallized stacked structural body is significantly shortened.

With regard to the temperature condition, there is no meaning in performing the stacked structural body-forming step by cooling the orientation control layer 4 to a temperature of less than room temperature, but the lower limit temperature at which the stacked structural body-forming step is performed is about -50°C.

In addition, temperature control in the stacked structural body-forming step is performed by, for example, substrate heating on a base substrate for forming the stacked structural body 7 including the orientation control layer 4.

### <Sb₂Te₃ Layer-crystallizing Step>

The Sb₂Te₃ layer-crystallizing step is a step of crystallizing the Sb₂Te₃ layer 5 by heating and holding the stacked structural body 7 at a first crystallization temperature.

The Sb₂Te₃ layer-crystallizing step may be performed under a vacuum atmosphere, or may be performed under an air atmosphere. In particular, when the step is performed under the air atmosphere, a manufacturing process for the crystallized stacked structural body is significantly simplified.

In addition, the Sb₂Te₃ layer-crystallizing step may be a step of heating part of the stacked structural body 7 or a step of heating the entirety of the stacked structural body 7.

An example of the heating of part of the stacked structural body 7 is an example in which after the various layers of the stacked structural body 7 have been formed in a large area, only a site required to produce the structure of the superlattice-type phase-change memory is heated.

Heating means is not particularly limited, and may be appropriately selected from known heating means in accordance with an embodiment of the Sb₂Te₃ layer-crystallizing step.

For example, when the step is performed under a vacuum atmosphere, the heating means is, for example, a vacuum vessel including a heating portion. When the step is performed under an air atmosphere, the heating means is, for example, a hot plate or a heating furnace. When the partial heating is performed, the heating means is, for example, partial heating means, such as a nichrome wire heater, a lamp heating apparatus, or a laser heating apparatus. In particular, when a condensed laser beam or the like is used, the superlattice-type phase-change memory can be built into a target position.

A holding time in the heating and the holding only needs to be 10 minutes or more. The upper limit of the holding time is about 2 hours because as the holding time lengthens, the manufacturing efficiency of the crystallized stacked structural body reduces.

The first crystallization temperature is set to a temperature of 100°C or more and less than 170°C.

A crystallization temperature when the Sb₂Te₃ layer 5 is a single layer, in other words, a crystallization temperature intrinsic to Sb₂Te₃ is identified at around 78°C. However, heating at a temperature extremely close to the crystallization temperature is not practical because the achievement of uniform crystallization requires a long time period. The reason therefor is as follows: even when atoms that have been stacked under the heating energy can produce covalent bonds with their adjacent atoms to produce crystal nuclei, additional energy for crystal growth around the crystal nuclei is further required. In other words, even when the atoms form covalent bonds with each other, unless a lattice match (the atoms are bonded to each other by rearranging their positions at an interface therebetween) can be achieved at an interface between fine crystals at the stage of the crystal growth, a large and uniform crystal cannot be formed, and hence additional energy required for the lattice match is further required.

Accordingly, the lower limit of the first crystallization temperature is set to 100°C that is higher than the crystallization temperature intrinsic to the Sb₂Te₃ layer 5 by several tens of degrees centigrade. In particular, the lower limit is preferably 120°C or more from the viewpoint of obtaining a satisfactory homogeneous film.

Meanwhile, the upper limit of the first crystallization temperature needs to be a temperature that does not exceed the crystallization temperature of the GeSbTe compound layer in which GeTe and Sb₂Te₃ are mixed. When the upper limit exceeds the temperature, the Sb₂Te₃ layer 5 and the GeTe layer 6 crystallize independently of each other, and hence the respective layers crystallize without sharing any crystal axis. Accordingly, a satisfactory superlattice structure is not obtained. Further, in addition, a GeTe fine crystal grain is liable to take in an Sb₂Te₃ fine crystal grain to produce a GeSbTe crystal layer.

Accordingly, the upper limit of the first crystallization temperature is less than 170°C. In particular, the upper limit is preferably 150°C or less from the viewpoint of obtaining a satisfactory homogeneous film.

### <GeTe Layer-crystallizing Step>

The GeTe layer-crystallizing step is a step of crystallizing the GeTe layer 6 by heating and holding the stacked structural body 7 in which the Sb₂Te₃ layer 5 is crystalized at a second crystallization temperature of 170°C or more and 400°C or less.

As in the Sb₂Te₃ layer-crystallizing step, the GeTe layer-crystallizing step may be performed under a vacuum atmosphere, or may be performed under an air atmosphere. In particular, when the step is performed under the air atmosphere, a manufacturing process for the crystallized stacked structural body is significantly simplified.

In addition, as in the Sb₂Te₃ layer-crystallizing step, the GeTe layer-crystallizing step may be a step of heating part of the stacked structural body 7 or a step of heating the entirety of the stacked structural body 7. When part of the stacked structural body 7 is heated, the stacked structural body 7, which includes part or the entirety of the region of the stacked structural body 7 heated in the Sb₂Te₃ layer-crystallizing step, is heated.

Heating means is not particularly limited, and the matters described for the Sb₂Te₃ layer-crystallizing step may each be applied.

As in the Sb₂Te₃ layer-crystallizing step, a holding time in the heating and the holding only needs to be 10 minutes or more. The upper limit of the holding time is about 2 hours because as the holding time lengthens, the manufacturing efficiency of the crystallized stacked structural body reduces.

The second crystallization temperature is set to a temperature of 170°C or more and 400°C or less.

The present invention is based on the finding that the first crystallization temperature at which the Sb₂Te₃ layer 5 is crystallized and the second crystallization temperature at which the GeTe layer 6 is crystallized are present in temperature regions that do not overlap each other. When those temperatures are a common temperature, the Sb₂Te₃ layer 5 and the GeTe layer 6 crystallize independently of each other, and hence the respective layers crystallize without sharing any crystal axis. Accordingly, a satisfactory superlattice structure is not obtained.

A crystallization temperature when the GeTe layer 6 is a single layer free of the trace addition element (S or Se), in other words, a crystallization temperature intrinsic to GeTe is present at around 230°C. However, when GeTe is formed as the thin GeTe layer 6 having a thickness of more than 0 nm and 4 nm or less, the layer cannot form any crystal nucleus by itself, and hence undergoes crystal growth through use of the (0001) interface of the Sb₂Te₃ layer 5 that has crystallized. Accordingly, thermal energy required for the formation of the crystal nucleus is not required, and hence the crystallization temperature of the layer becomes lower than the intrinsic temperature. In addition, at the time of the performance of the Sb₂Te₃ layer-crystallizing step serving as the previous step, the volume of the Sb₂Te₃ layer 5 shrinks along with its crystallization. At this stage, a large compressive stress occurs in the GeTe layer 6 in an amorphous state. The compressive stress also makes the crystallization temperature of the GeTe layer 6 lower than the intrinsic crystallization temperature. Further, the shrinkage of a crystal lattice caused by the addition of the trace addition element causes a lattice mismatch, and hence the addition of the trace addition element largely affects the crystallization temperature even when the element is added in a trace amount. When the Sb₂Te₃ layer 5 and the GeTe layer 6 form a superlattice structure while sharing the (111) plane direction axis of a GeTe crystal and the (0001) plane direction axis of an Sb₂Te₃ crystal, their lattice constants are 4.172 Å and 4.262 Å, respectively, and hence there is a mismatch of about 2% therebetween.

As a result, in the GeTe layer 6 in a state in which the Sb₂Te₃ layer 5 and the GeTe layer 6 are stacked, its crystallization temperature is identified at around 160°C under a state in which the layer is free of the trace addition element.

Meanwhile, as shown in FIG. 3, when the GeTe layer 6 contains the trace addition element (a S atom or a Se atom), the crystallization temperature of the GeTe layer 6 increases with increasing content of the trace addition element. In particular, in the GeTe layer 6 in a state in which the Sb₂Te₃ layer 5 and the GeTe layer 6 are stacked, the addition of a slight amount of the trace addition element to the GeTe layer 6 significantly increases the temperature as compared to that of the GeTe layer 6 in a single-layer state. FIG. 3 is a graph for showing a relationship between the substitution concentration at which a Te atom in the GeTe layer 6 (Ge₍₄₅₎Te₍₅₅₋ₓ₎S₍ₓ₎) is substituted with a S atom and the crystallization temperature of the layer. A series indicated by a straight line "1" is intended for the GeTe layer 6 in a single-layer state and a series indicated by a broken line "2" is intended for the GeTe layer 6 in a stacked state.

Accordingly, in consideration of an increase by the trace addition element, the lower limit of the second crystallization temperature is set to 170°C. In particular, the lower limit is preferably 200°C or more from the viewpoint of obtaining a satisfactory homogeneous film.

The upper limit of the second crystallization temperature is about 400°C at which no film oxidation occurs. When the upper limit is much more than 400°C, an X-ray diffraction peak derived from the GeSbTe crystal layer is observed, and hence a satisfactory superlattice structure is not obtained. Even a temperature of about 300°C suffices for the upper limit of the second crystallization temperature from the viewpoint of shortening a temperature increase time while obtaining a satisfactory homogeneous film.

Thus, a crystallized stacked structural body 1 in which the stacked structural body 7 is crystallized is formed.

The Sb₂Te₃ layer-crystallizing step and the GeTe layer-crystallizing step are preferably performed for the plurality of stacked structural bodies 7. When such performance method is adopted, the steps become batch processing for the plurality of stacked structural bodies 7, and hence a manufacturing time for the crystallized stacked structural body can be shortened.

### <Other Step>

The other step is not particularly limited, and examples thereof include a protective layer-forming step and an epitaxial growth layer-forming step.

The protective layer-forming step is a step of forming a protective layer on the stacked structural body 7.

The protective layer is not particularly limited, and is, for example, a known protective layer to be formed at the time of the production of a device.

A layer represented by reference numeral 8 in each of FIG. 1 and FIG. 2 corresponds to the protective layer.

The epitaxial growth layer-forming step is a step of forming an epitaxial growth layer on the stacked structural body 7 after the GeTe layer-crystallizing step.

In the method of manufacturing a crystallized stacked structural body of the present invention, the crystal layers of the Sb₂Te₅ layer 5 and the GeTe layer 6 formed of large crystal grains are produced.

Accordingly, when the epitaxial growth layer is formed on the stacked structural body 7, the epitaxial growth layer formed of large crystal grains is easily obtained.

The configuration of the epitaxial growth layer is not particularly limited, and the layer may be a layer including Sb₂Te₅ or GeTe, or may be a layer formed of an arbitrary formation material.

In the case where the epitaxial growth layer is the layer including Sb₂Te₃ or GeTe, the stacking fault of the stacked structural body 7 may be removed by forming the layer through film formation by heating in the related-art method. In this case, when the epitaxial growth layer-forming step is continuously performed after the GeTe layer-crystallizing step, a temperature increase time in substrate heating required for the film formation by heating can be omitted.

### Examples

### (Crystallization Temperature of Single Layer)

Premeasurement for identifying the crystallization temperatures of the GeTe layer and the Sb₂Te₃ layer was performed.

First, a Ge₄₅Te₅₂S₃ (containing 3 at% of S) target and a Ge₄₅Te₄₅S₁₀ (containing 10 at% of S) target each obtained by substituting part of Te in a Ge₄₅Te₅₅ material with S were each prepared as a target for forming a GeTe layer. In addition, an Sb₃₀Te₇₀ target whose composition had been adjusted was prepared as a target for forming an Sb₂Te₃ layer.

Next, sputtering based on those three targets was performed with a sputtering apparatus (manufactured by ULVAC, Inc., QAM) under room temperature to form, on a SiN thin film formed on a sample production unit dedicated for a flash differential scanning calorimeter (Flash DSC) manufactured by Mettler-Toledo International Inc., a Ge₄₅Te₅₂S₃ layer, a Ge₄₅Te₄₅S₁₀ layer and an Sb₂Te₃ layer, which were amorphous and were each formed of a single layer, so that the layers each had a thickness of 50 nm. The film formation was performed under the following film formation conditions: a RF power of 20 W was applied at a pressure of 0.5 Pa.

Next, the crystallization temperature of each of the Ge₄₅Te₅₂S₃ layer, the Ge₄₅Te₄₅S₁₀ layer and the Sb₂Te₃ layer was measured with the differential thermal analyzer. The measurement was performed under such a condition that the temperature increase rate of the differential calorimeter was set to 10°C/sec.

The measurement results of the crystallization temperatures in single-layer states are shown in Table 1 below.

**Table 1**

| Alloy layer | Crystallization temperature (°C) |
|---|---|
| Ge₄₅Te₅₂S₃ | 245 |
| Ge₄₅Te₄₅S₁₀ | 264 |
| Sb₂Te₃ | 78 |

As shown in Table 1 above, it is recognized that in the GeTe layer, the crystallization temperature increases with increasing S content.

### (Crystallization Temperature of Stacked Structural Body: Samples A to C)

Premeasurement for identifying the crystallization temperature in a state in which the GeTe layer and the Sb₂Te₃ layer were stacked was performed.

First, the Ge₄₅Te₅₂S₅ target and the Sb₃₀Te₇₀ target were set in the sputtering apparatus, and the Ge₄₅Te₅₂S₃ layer having a thickness of 0.8 nm and an Sb₂Te₃ layer having a thickness of 4.0 nm were alternately formed in the stated order eight times on the SiN thin film of the sample production unit under room temperature. Thus, a stacked structural body according to a sample A having formed therein a total of 16 compound layers was obtained.

The thicknesses were adjusted by adjusting the time and power of the sputtering. In addition, the sputtering was performed under the following conditions: a vacuum degree was set to 2×10⁻⁴ Pa, an argon gas pressure was set to 0.5 Pa, and a RF power of 20 W was applied to each of the targets. The time of the sputtering, which depends on the composition of each target, is from 15 seconds to 25 seconds per nm of thickness. The sputtering time was determined by a thickness per time measured with a step gauge after film formation had been performed in advance with a Si substrate for a predetermined time period.

Next, a stacked structural body according to a sample B having a total of 16 layers formed on the SiN thin film of the sample production unit, the layers including the Ge₄₅Te₄₅S₁₀ layer and the Sb₂Te₃ layer, was obtained in the same manner as in the method of forming the stacked structural body according to the sample A except that the Ge₄₅Te₄₅S₁₀ target was used instead of the Ge₄₅Te₅₂S₃ target.

Next, a stacked structural body according to a sample C having a total of 16 layers formed on the SiN thin film of the sample production unit, the layers including the GeTe layer and the Sb₂Te₃ layer, was obtained in the same manner as in the method of forming the stacked structural body according to the sample A except that a Ge₄₅Te₅₅ target (manufactured by Mitsubishi Materials Corporation, 2 inches) to which S was not added was prepared, and the Ge₄₅Te₅₅ target was used instead of the Ge₄₀Te₅₂S₃ target.

The crystallization temperature of each of the stacked structural bodies according to the samples A to C was measured with the differential thermal analyzer in the same manner as in the case of the single layer.

The measurement results of the crystallization temperatures in stacked states are shown in Table 2 below.

**Table 2**

| Sample | First crystallization temperature (°C) | Second crystallization temperature (°C) |
|---|---|---|
| A | 72 | 218 |
| B | 72 | 232 |
| C | 72 | 162 |

As shown in Table 2 above, in each of the stacked structural bodies according to the samples A and B, the first crystallization temperature was identified at 72°C, and the second crystallization temperature was identified at 218°C or 232°C.

Meanwhile, in the stacked structural body according to the sample C, a crystallization temperature was also identified at around 160°C. That is, first, a first crystallization temperature was identified at around 72°C, and then, a second crystallization temperature was identified in the temperature region of 162°C or more.

This is probably because substitution between an Sb atom and a Ge atom due to interface diffusion (interface mixing) occurred to form the GeSbTe crystal layer at an interface between the GeTe layer and the Sb₂Te₃ layer.

It is recognized from the foregoing results that each of the stacked structural bodies according to the samples A and B each containing the trace addition element has two crystallization temperatures corresponding to the GeTe layer and the Sb₂Te₃ layer, and these layers are crystallized while a sufficient temperature difference is secured between the two crystallization temperatures.

### (Reference Example 1)

Next, a crystallized stacked structural body according to Reference Example 1 was manufactured in conformity with the related art (see, for example, Patent Document 3 (WO 2020/012916 A1) listed above). Specifically, the manufacture was performed by the following manufacturing method.

First, a 200-micrometer sapphire substrate (manufactured by Shinkosha Co., Ltd.) was transferred to the sputtering apparatus, and sputtering using a silicon material (manufactured by Mitsubishi Materials Corporation, B-doped Si) as a target was performed under the conditions of a vacuum back pressure of 1.0×10⁻⁴ Pa, a film-forming gas pressure of Ar of 0.5 Pa, a temperature of 25°C and a RF power of 100 W. Thus, an amorphous silicon layer serving as an underlayer was formed on the sapphire substrate so as to have a thickness of 50 nm.

Next, sputtering using the Sb₂Te₃ target was performed under the conditions of an argon gas pressure of 0.5 Pa, a temperature of 25°C and a RF power of 20 W while the vacuum back pressure was maintained. Thus, the Sb₂Te₃ underlayer was formed on the amorphous silicon layer so as to have a thickness of 4.0 nm. In addition, after the formation, the sapphire substrate was heated at 210°C to crystallize the Sb₂Te₃ underlayer.

Next, sputtering was performed with the Ge₄₅Te₅₂S₃ target under the condition of a RF power of 20 W while the vacuum back pressure and the film-forming gas pressure of Ar were maintained, and the substrate heating temperature was held at 210°C. Thus, the GeTe layer containing a S atom at a content of 3 at% was formed on the Sb₂Te₃ underlayer so as to have a thickness of 0.8 nm, and was crystallized.

Next, the Sb₂Te₃ layer was formed on the GeTe layer under the same film-forming conditions as those of the Sb₂Te₃ underlayer so as to have a thickness of 4.0 nm, and was crystallized.

Next, the GeTe layer and the Sb₂Te₃ layer were each alternately and repeatedly stacked under the same conditions as those of the first layer. Thus, the crystallized stacked structural body in which a total of 16 layers formed of 8 of each of the Sb₂Te₃ layer and the GeTe layer that had been crystallized were alternately stacked was formed.

Finally, a tungsten (W) layer serving as a protective layer was formed on the Sb₂Te₃ layer serving as the uppermost layer of the crystallized stacked structural body with the sputtering apparatus so as to have a thickness of 20 nm.

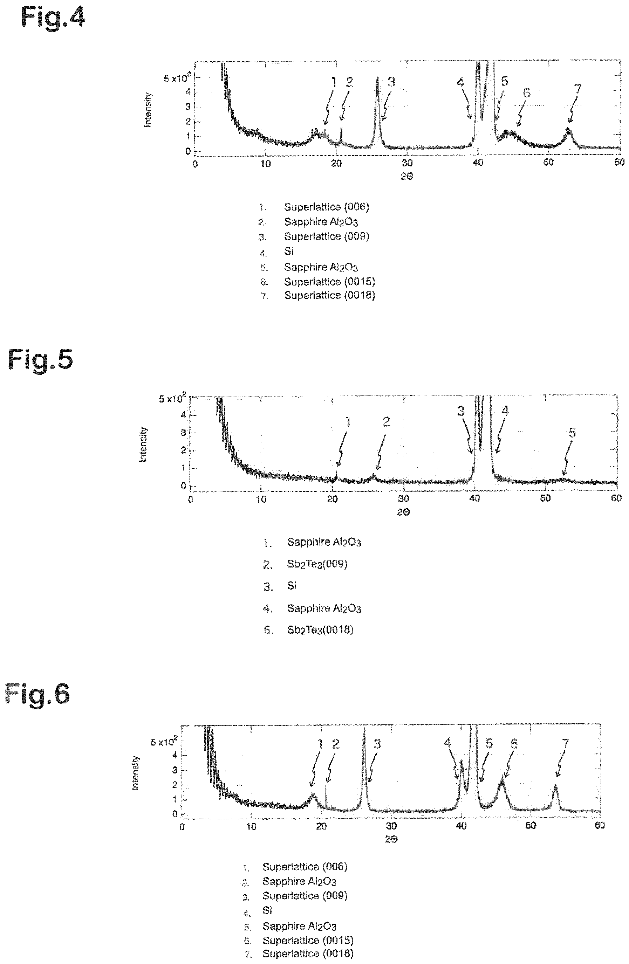

Next, the crystallized stacked structural body according to Reference Example 1 thus manufactured was subjected to X-ray diffractometry with an X-ray diffraction apparatus (manufactured by Rigaku Corporation, sample horizontal-type multipurpose X-ray diffraction apparatus). The measurement results are shown in FIG. 4.

As shown in FIG. 4, in the crystallized stacked structural body according to Reference Example 1, the respective peaks corresponding to (006), (009), (0015) and (0018) planes that corroborate the formation of a superlattice structure by the stacked structure of the GeTe layer and the Sb₂Te₃ layer that have been crystallized can be observed. Accordingly, it is confirmed that the crystallized stacked structural body has the superlattice structure that has heretofore been reported, the structure being obtained by subjecting the GeTe layer and the Sb₂Te₃ layer to crystal growth with their common crystal axis.

### (Example 1)

Next, the stacked structural body formed by film formation at room temperature without heating of the sapphire substrate at 210°C was heated and held in two stages at two crystallization temperatures after the film formation to manufacture a crystallized stacked structural body according to Example 1. Specifically, the manufacture was performed by the following manufacturing method.

First, the amorphous silicon layer was formed on the sapphire substrate so as to have a thickness of 50 nm with the sputtering apparatus in the same manner as in Reference Example 1.

Next, the GeTe underlayer (containing 3 at% of a S atom) was formed with the Ge₄₅Te₅₂S₃ target on the amorphous silicon layer so as to have a thickness of 3.2 nm under the same conditions as the conditions for the sputtering at the time of the formation of each of the stacked structural bodies according to the samples A to C to be performed under room temperature.

Next, the Sb₂Tea layer was formed with the Sb₃₀Te₇₀ target on the GeTe underlayer so as to have a thickness of 4.0 nm while the same conditions as the conditions for the sputtering at the time of the formation of each of the stacked structural bodies according to the samples A to C to be performed under room temperature were kept.

Next, the GeTe layer (containing 3 at% of a S atom) was formed with the Ge₄₅Te₅₂S₃ target on the Sb₂Te₃ layer so as to have a thickness of 0.8 nm while the same conditions as the conditions for the sputtering at the time of the formation of each of the stacked structural bodies according to the samples A to C to be performed under room temperature were kept.

Next, the Sb₂Te₃ layer and the GeTe layer were each alternately and repeatedly stacked under the same conditions as those of the first layer. Thus, the stacked structural body in which a total of 16 layers formed of 8 of each of the Sb₂Te₃ layer and the GeTe layer were alternately stacked was formed (the stacked structural body-forming step).

In addition, the tungsten (W) layer serving as a protective layer was formed on the GeTe layer serving as the uppermost layer of the stacked structural body with the sputtering apparatus so as to have a thickness of 20 nm while a room temperature condition was maintained.

Next, the sapphire substrate having formed thereon the stacked structural body was removed from the sputtering apparatus, and was then set in a vacuum vessel (manufactured by ULVAC, Inc., infrared lamp annealing apparatus), followed by heating and holding under the conditions of a vacuum degree of 1×10⁻⁴ Pa, a heating temperature of 140°C and a holding time of 0.5 hour. Thus, the Sb₂Te₃ layer was crystallized (the Sb₂Te₃ layer-crystallizing step).

The sapphire substrate in which the Sb₂Te₃ layer had been crystallized was removed from the vacuum vessel once, and was subjected to X-ray diffractometry with the X-ray diffraction apparatus. The measurement results are shown in FIG. 5.

As shown in FIG. 5, crystal peaks corresponding to (009) and (0018) planes of Sb₂Te₃ that corroborate the formation of the Sb₂Te₃ layer that has been crystallized can be observed.

The sapphire substrate having formed thereon the stacked structural body was set in the vacuum vessel again, and this time, the substrate was heated and held under the conditions of a vacuum degree of 1×10⁻⁴ Pa, a heating temperature of 230°C and a holding time of 0.5 hour. Thus, the GeTe layer was crystallized (the GeTe layer-crystallizing step).

Thus, the crystallized stacked structural body according to Example 1 was manufactured.

Subsequently, the crystallized stacked structural body according to Example 1 after its cooling was subjected to X-ray diffractometry with the X-ray diffraction apparatus. The measurement results are shown in FIG. 6.

As shown in FIG. 6, in addition to the crystal peaks corresponding to (009) and (0018) planes of Sb₂Te₃, crystal peaks corresponding to (006) and (0015) planes of GeTe that corroborate the formation of the GeTe layer that has been crystallized can be observed.

In addition, the measurement results of the X-ray diffractometry of the crystallized stacked structural body according to Example 1 shown in FIG. 6 are quite similar to the measurement results of the X-ray diffractometry of the crystallized stacked structural body according to Reference Example 1 shown in FIG. 4. While the respective peaks corresponding to (006), (009), (0015) and (0018) planes are observed in each of both the structural bodies, no peaks other than those peaks are observed. Accordingly, in the crystallized stacked structural body according to Example 1, as in the crystallized stacked structural body according to Reference Example 1 manufactured by the related-art method, the superlattice structure in which the GeTe layer and the Sb₂Te₃ layer have been subjected to crystal growth with their common crystal axis can be formed.

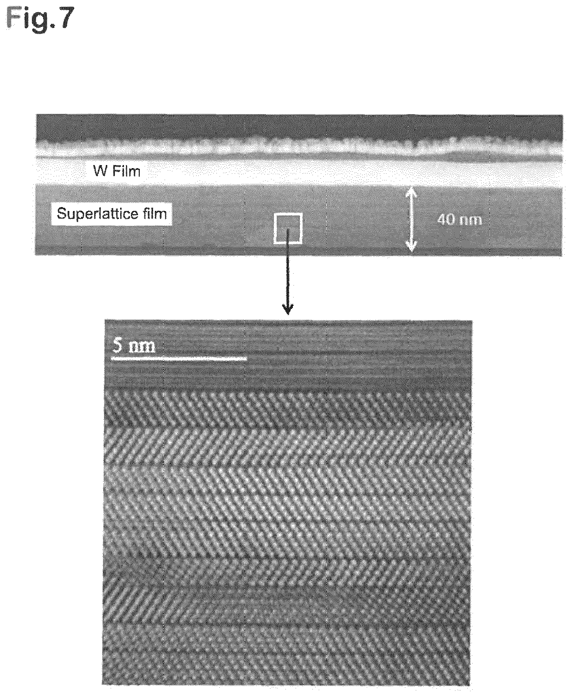

In addition, an image obtained by observing a section of the crystallized stacked structural body according to Example 1 with a high-resolution transmission electron microscope (manufactured by JEOL Ltd., scanning transmission electron microscope) is shown in FIG. 7.

As shown in FIG. 7, in the crystallized stacked structural body according to Example 1, the superlattice structure having a uniform crystal orientation property in which the atomic arrangement of the GeTe layer and the Sb₂Te₃ layer is uniformized is obtained.

### (Example 2)

A crystallized stacked structural body according to Example 2 was manufactured in the same manner as in Example 1 except that: heating and holding were performed with a hot plate (manufactured by Yamato Scientific Co., Ltd., Hot Plate) under an air atmosphere and under the conditions of a heating temperature of 140°C and a holding time of 0.5 hour (the Sb₂Te₃ layer-crystallizing step) instead of the performance of the heating and the holding with the vacuum vessel under the conditions of a vacuum degree of 1×10⁻⁴ Pa, a heating temperature of 140°C and a holding time of 0.5 hour; and heating and holding were performed with the hot plate under the air atmosphere and under the conditions of a heating temperature of 230°C and a holding time of 0.5 hour (the GeTe layer-crystallizing step) instead of the performance of the heating and the holding with the vacuum vessel under the conditions of a vacuum degree of 1×10⁻⁴ Pa, a heating temperature of 230°C and a holding time of 0.5 hour.

Subsequently, the crystallized stacked structural body according to Example 2 after its cooling was subjected to X-ray diffractometry with the X-ray diffraction apparatus.

Surprisingly, measurement results substantially the same as those of FIG. 6 were obtained. Accordingly, even in the crystallized stacked structural body according to Example 2 whose layers have been crystallized under the air atmosphere, the superlattice structure in which the GeTe layer and the Sb₂Te₃ layer have been subjected to crystal growth with their common crystal axis can be formed.

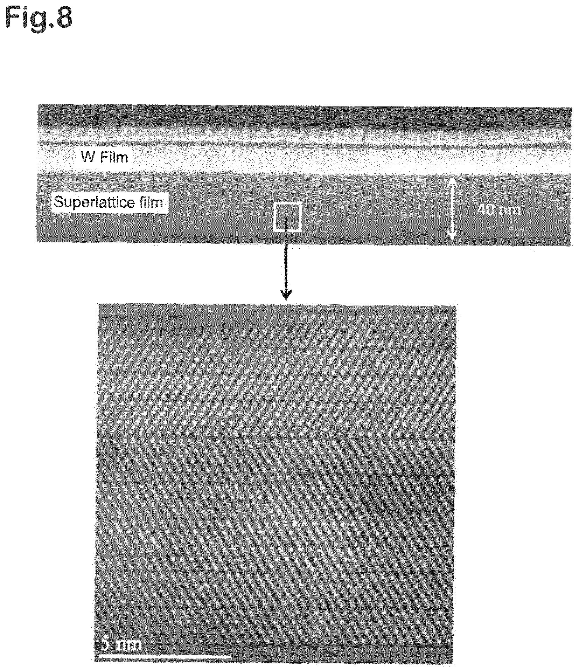

In addition, an image obtained by observing a section of the crystallized stacked structural body according to Example 2 with the high-resolution transmission electron microscope is shown in FIG. 8.

As shown in FIG. 8, even in the crystallized stacked structural body according to Example 2, as in the crystallized stacked structural body according to Example 1 (see FIG. 7), the superlattice structure having a uniform crystal orientation property in which the atomic arrangement of the GeTe layer and the Sb₂Te₃ layer is uniformized is obtained.

As can be seen from the foregoing, the Sb₂Te₃ layer-crystallizing step and the GeTe layer-crystallizing step may be performed under the air atmosphere instead of being performed under a vacuum atmosphere.

### (Comparative Example 1)

A crystallized stacked structural body according to Comparative Example 1 was manufactured in the same manner as in Example 1 except that: the heating temperature in the Sb₂Te₃ layer-crystallizing step was changed from 140°C to 80°C; and the heating temperature in the GeTe layer-crystallizing step was changed from 230°C to 220°C.

The crystallized stacked structural body according to Comparative Example 1 was subjected to X-ray diffractometry with the X-ray diffraction apparatus. As a result, the respective peaks corresponding to (006), (009), (0015) and (0018) planes by which the formation of the superlattice structure was able to be recognized appeared, but the height of each of the peaks was about a half as high as that of each of the crystallized stacked structural bodies according to Examples 1 and 2.

The heating temperature in the GeTe layer-crystallizing step is substantially the same as that of Example 1. Accordingly, it is assumed from the foregoing result that the crystallization of each of Sb₂Te₃ and GeTe led to the formation of the superlattice structure under a state in which its crystal grains were small because the crystallization of the Sb₂Te₃ layer did not sufficiently advance owing to the low heating temperature in the Sb₂Te₃ layer-crystallizing step, and hence the crystallization of the GeTe layer was performed on the Sb₂Te₃ layer in the state.

### (Comparative Example 2)

A crystallized stacked structural body according to Comparative Example 2 was manufactured in the same manner as in Example 1 except that: the heating temperature in the Sb₂Te₃ layer-crystallizing step was changed from 140°C to 180°C; and the heating temperature in the GeTe layer-crystallizing step was changed from 230°C to 220°C.

The crystallized stacked structural body according to Comparative Example 2 was subjected to X-ray diffractometry with the X-ray diffraction apparatus. As a result, the respective peaks corresponding to (006) and (009) planes appeared, but a peak corresponding to a (220) plane observed in the GeSbTe crystal layer was observed. Accordingly, it is recognized that the GeSbTe crystal layer that was not involved in the memory operation of the superlattice-type phase-change memory was formed in part of the structural body.

The heating temperature in the GeTe layer-crystallizing step is substantially the same as that of Example 1. Accordingly, it is assumed from the foregoing result that the crystallization of the Sb₂Te₅ layer and the crystallization of the GeTe layer advanced independently of each other owing to the high heating temperature in the Sb₂Te₃ layer-crystallizing step, and hence these layers were crystallized without sharing any crystal axis. In addition, it is assumed that when the crystallization of an Sb₂Te₃ crystal grain and GeTe advances under high temperature, a GeTe fine crystal grain takes in an Sb₂Te₃ fine crystal grain to form the GeSbTe crystal layer.

### (Comparative Example 3)

A crystallized stacked structural body according to Comparative Example 3 was manufactured in the same manner as in Example 1 except that the heating temperature in the GeTe layer-crystallizing step was changed from 230°C to 450°C.

The crystallized stacked structural body according to Comparative Example 3 was subjected to X-ray diffractometry with the X-ray diffraction apparatus. As a result, the peak corresponding to a (009) plane appeared, but the respective peaks corresponding to (200) and (220) planes observed in the GeSbTe crystal layer became higher. Accordingly, it is recognized that the GeSbTe crystal layer that was not involved in the memory operation of the superlattice-type phase-change memory was largely formed.

It is assumed from the foregoing result that the GeTe layer underwent crystal growth while partially taking in Sb₂Tea to lose its orientation property because the crystallization of the GeTe layer was subjected to high-temperature heating exceeding its limit to abruptly advance at a rate exceeding the crystal growth rate at which the orientation template of the Sb₂Tea layer was able to be utilized.

### Reference Signs List

- 1: crystallized stacked structural body
- 2: substrate
- 3: basic underlayer
- 4: orientation control layer
- 5: Sb₂Te₃ layer
- 6: GeTe layer
- 7: stacked structural body
- 8: protective layer.

## Claims

1. A method of manufacturing a crystallized stacked structural body, comprising:
a stacked structural body-forming step of forming a stacked structural body in which an Sb₂Te₃ layer, which contains Sb₂Te₃ as a main component thereof and has a thickness of from 2 nm to 10 nm, and a GeTe layer, which contains GeTe as a main component thereof and has a thickness of more than 0 nm and 4 nm or less, are stacked, and at least one trace addition element selected from a group consisting of S and Se is incorporated at a content of from 0.05 at% to 10.0 at% into the GeTe layer on an orientation control layer configured to give, to the Sb₂Te₃ layer and the GeTe layer at a time of crystallization thereof, a common crystal axis, the step being performed under a temperature of less than 100°C including room temperature;
an Sb₂Te₃ layer-crystallizing step of crystallizing the Sb₂Te₃ layer by heating and holding the stacked structural body at a first crystallization temperature of 100°C or more and less than 170°C; and
a GeTe layer-crystallizing step of crystallizing the GeTe layer by heating and holding the stacked structural body in which the Sb₂Te₃ layer is crystallized at a second crystallization temperature of 170°C or more and 400°C or less.

2. The method of manufacturing a crystallized stacked structural body according to claim 1, wherein the trace addition element is S.

3. The method of manufacturing a crystallized stacked structural body according to claim 1 or 2, wherein the stacked structural body-forming step is a step of forming the stacked structural body by using, as the orientation control layer, at least one underlayer selected from a group consisting of a GeTe underlayer, which contains GeTe as a main component thereof and has a thickness of from 3 nm to 10 nm, and an Sb₂Te₃ underlayer, which contains Sb₂Te₃ as a main component thereof and has a thickness of from 3 nm to 10 nm, and stacking the Sb₂Te₃ layer and the GeTe layer in a stated order on the underlayer when the underlayer is the GeTe underlayer or stacking the GeTe layer and the Sb₂Te₃ layer in a stated order on the underlayer when the underlayer is the Sb₂Te₃ underlayer.

4. The method of manufacturing a crystallized stacked structural body according to any one of claims 1 to 3, wherein the stacked structural body-forming step is a step of forming the stacked structural body on the orientation control layer in an unheated state under room temperature.

5. The method of manufacturing a crystallized stacked structural body according to any one of claims 1 to 4, wherein the Sb₂Te₃ layer-crystallizing step and the GeTe layer-crystallizing step are performed for a plurality of stacked structural bodies.

6. The method of manufacturing a crystallized stacked structural body according to any one of claims 1 to 5, wherein at least one step selected from a group consisting of the Sb₂Te₃ layer-crystallizing step and the GeTe layer-crystallizing step is performed under an air atmosphere.

7. The method of manufacturing a crystallized stacked structural body according to any one of claims 1 to 6, wherein the Sb₂Te₃ layer-crystallizing step is performed as at least one step selected from a group consisting of a step of heating part of the stacked structural body and a step of heating an entirety of the stacked structural body, and the GeTe layer-crystallizing step is a step of heating the stacked structural body including part or an entirety of a region of the stacked structural body heated in the Sb₂Te₃ layer-crystallizing step.

8. The method of manufacturing a crystallized stacked structural body according to any one of claims 1 to 7, further comprising an epitaxial growth layer-forming step of forming an epitaxial growth layer on the stacked structural body after the GeTe layer-crystallizing step.
